(19) Europäisches Patentamt
European Patent Office
Office européen des brevets

(11) **EP 4 393 332 A1**

(12) **EUROPEAN PATENT APPLICATION**
published in accordance with Art. 153(4) EPC

(43) Date of publication:
**03.07.2024 Bulletin 2024/27**

(21) Application number: **22885955.9**

(22) Date of filing: **25.10.2022**

(51) International Patent Classification (IPC):
**A24F 40/465** (2020.01)    **A24F 40/40** (2020.01)

(52) Cooperative Patent Classification (CPC):
**A24F 40/40; A24F 40/465**

(86) International application number:
**PCT/CN2022/127396**

(87) International publication number:
**WO 2023/072078 (04.05.2023 Gazette 2023/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.10.2021 CN 202111252866**

(71) Applicant: **Shenzhen First Union Technology Co.,
Ltd.
Shenzhen, Guangdong 518000 (CN)**

(72) Inventors:
• **HE, Huanjie
  Shenzhen, Guangdong 518000 (CN)**
• **XU, Zhongli
  Shenzhen, Guangdong 518000 (CN)**
• **LI, Yonghai
  Shenzhen, Guangdong 518000 (CN)**

(74) Representative: **Jacob, Reuben Ellis et al
Maucher Jenkins
Seventh Floor Offices
Artillery House
11-19 Artillery Row
London SW1P 1RT (GB)**

(54) **AEROSOL GENERATING DEVICE AND CONTROL METHOD THEREFOR**

(57)    This application provides an aerosol generating device and a control method therefor. The aerosol generating device includes: a battery cell, configured to supply power; a thermosensitive element, a resistance value thereof varying depending on a heating temperature; a sampling resistor, configured to be electrically connected to the thermosensitive element to form a detection loop; and a controller, configured to determine the heating temperature according to a ratio of any two electrical characteristics of an electrical characteristic of the detection loop, an electrical characteristic of the sampling resistor, and an electrical characteristic of the thermosensitive element. In the aerosol generating device, the detection loop is constructed through the sampling resistor and the thermosensitive element, and a temperature for heating an aerosol-forming substrate is determined according to the ratio of any two electrical characteristics of the electrical characteristic of the detection loop, the electrical characteristic of the sampling resistor, and the electrical characteristic of the thermosensitive element, thereby facilitating temperature control.

FIG. 3

EP 4 393 332 A1

## Description

## CROSS-REFERENCE TO RELATED APPLICATIONS

This application claims priority to Chinese Patent Application No. 202111252866.8, filed with the China National Intellectual Property Administration on October 27, 2021 and entitled "AEROSOL GENERATING DEVICE AND CONTROL METHOD THEREFOR", which is incorporated herein by reference in its entirety.

## TECHNICAL FIELD

Embodiments of this application relate to the field of electronic atomization technologies, and in particular, to an aerosol generating device and a control method therefor.

## BACKGROUND

Tobacco products (such as cigarettes, cigars, and the like) burn tobacco during use to produce tobacco smoke. Attempts are made to replace these tobacco-burning products by manufacturing products that release compounds without burning.

An example of this type of products is a heat-not-burn apparatus that releases compounds by heating rather than burning materials. For example, the materials may be tobacco or other non-tobacco products. These non-tobacco products may include or not include nicotine. An electronic atomization apparatus, serving as another example, usually includes liquid, and the liquid is heated to be atomized by a heating element, so as to generate an inhalable aerosol. The liquid may include nicotine, aromatics, and/or aerosol-generating substances (such as glycerin).

The foregoing heating apparatus generally determines a working temperature of the heating element by calculating a resistor resistance value having a temperature coefficient. To avoid interference caused by an unstable power supply, a filter circuit needs to be added to ensure the accuracy of the calculated resistor resistance value.

## SUMMARY

An embodiment of this application provides an aerosol generating device, configured to heat an aerosol-forming substrate to generate an aerosol, including:

> a battery cell, configured to supply power;
> a thermosensitive element, a resistance value thereof varying depending on a heating temperature;
> a sampling resistor, configured to be electrically connected to the thermosensitive element to form a detection loop; and
> a controller, configured to determine the heating temperature according to a ratio of any two electrical characteristics of an electrical characteristic of the detection loop, an electrical characteristic of the sampling resistor, and an electrical characteristic of the thermosensitive element.

In an example, the controller is further configured to detect the any two electrical characteristics.

In an example, the controller is further configured to obtain the heating temperature according to the ratio and pre-stored correspondence data between ratios and heating temperatures.

In an example, the controller is further configured to query the correspondence data.

In an example, the sampling resistor is connected to the thermosensitive element in series.

The electrical characteristic includes a voltage; and

the ratio includes at least one of the following:

a ratio of a voltage between two ends of the detection loop to a voltage between two ends of the sampling resistor, a ratio of the voltage between the two ends of the detection loop to a voltage between two ends of the thermosensitive element, or a ratio of the voltage between the two ends of the sampling resistor to the voltage between the two ends of the thermosensitive element.

In an example, the sampling resistor is connected to the thermosensitive element in parallel.

The electrical characteristic includes a current; and

the ratio includes a ratio of a current flowing through the sampling resistor to a current flowing through the thermosensitive element.

In an example, the aerosol generating device further includes a switch tube, where

the controller is further configured to control the switch tube to turn on or turn off an electrical connection between the detection loop and the battery cell.

In an example, the aerosol generating device further includes a heating element, configured to heat the aerosol-forming substrate, where

the thermosensitive element is arranged adjacent to the heating element.

In an example, the thermosensitive element is configured to heat the aerosol-forming substrate.

In an example, the aerosol-forming substrate is in a solid form or a liquid form.

An embodiment of this application further provides an aerosol generating device, configured to heat an aerosol-forming substrate to generate an aerosol, including:

> a battery cell, configured to supply power;
> a thermosensitive element, a resistance value thereof varying depending on a heating temperature;
> a sampling resistor, configured to be electrically connected to the thermosensitive element to form a detection loop; and
> a controller, configured to control a ratio of any two electrical characteristics of an electrical characteristic of the detection loop, an electrical characteristic of the sampling resistor, and an electrical characteristic of the thermosensitive element to be kept as a preset value or fall within a preset range.

An embodiment of this application further provides an aerosol generating device, including:

a battery cell, configured to supply power;
a heating element, configured to heat an aerosol-forming substrate to generate an aerosol;
a sampling resistor, configured to be electrically connected to the heating element to form a detection loop; and
a controller, configured to determine a heating temperature of the heating element according to a ratio of any two electrical characteristics of an electrical characteristic of the detection loop, an electrical characteristic of the sampling resistor, and an electrical characteristic of the heating element.

Another embodiment of this application further provides a control method for an aerosol generating device, the method including:
determining a ratio according to any two electrical characteristics of an electrical characteristic of a detection loop, an electrical characteristic of a sampling resistor, and an electrical characteristic of a thermosensitive element, and determining a temperature for heating an aerosol-forming substrate.

In the aerosol generating device, the detection loop is constructed through the sampling resistor and the thermosensitive element, and a temperature for heating an aerosol-forming substrate is determined according to the ratio of any two electrical characteristics of the electrical characteristic of the detection loop, the electrical characteristic of the sampling resistor, and the electrical characteristic of the thermosensitive element, thereby facilitating temperature control.

**BRIEF DESCRIPTION OF THE DRAWINGS**

One or more embodiments are exemplarily described with reference to the corresponding figures in the accompanying drawings, and the descriptions do not constitute a limitation to the embodiments. Elements in the accompanying drawings that have same reference numerals are represented as similar elements, and unless otherwise particularly stated, the figures in the accompanying drawings are not drawn to scale.

FIG. 1 is a schematic diagram of an aerosol generating device according to an embodiment of this application;
FIG. 2 is a schematic diagram of another aerosol generating device according to an embodiment of this application;

FIG. 3 is a schematic diagram of basic components of an embodiment of a circuit according to an embodiment of this application;
FIG. 4 is a schematic diagram of basic components of another embodiment of a circuit according to an embodiment of this application;
FIG. 5 is a schematic diagram of basic components of still another embodiment of a circuit according to an embodiment of this application;
FIG. 6 is a schematic diagram of basic components of still another embodiment of a circuit according to an embodiment of this application; and
FIG. 7 is a schematic diagram of a control process of an aerosol generating device according to an embodiment of this application.

**DETAILED DESCRIPTION**

For ease of understanding of this application, this application is described in further detail below with reference to the accompanying drawings and specific implementations.

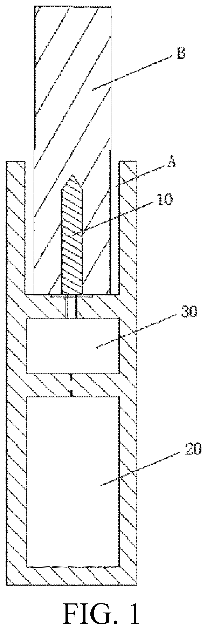

FIG. 1 is a schematic diagram of an aerosol generating device according to an implementation of this application.

As shown in FIG. 1, the aerosol generating device includes:

a chamber A, where an aerosol generating article B is removably received in the chamber A;
a heating element 10, where when the aerosol generating article B is received in the chamber A, the heating element 10 may be inserted into the aerosol generating article B to perform heating, so as to generate an aerosol;
a battery cell 20, configured to supply power; and
a circuit 30, arranged between the battery cell 20 and the heating element 10. The circuit 30 is configured to control the aerosol generating device. For example, the battery cell 20 supplies power to the heating element 10.

Preferably, the aerosol generating article B is a material containing tobacco that releases volatile compounds from a substrate when being heated; or a non-tobacco material that can be suitable for electrical heating smoke generation after being heated. Preferably, the aerosol generating article B uses a solid substrate, which may include one or more of powders, particles, shreds, strips, or flakes of one or more of a vanilla leaf, a tobacco leaf, homogenized tobacco, or expanded tobacco. Alternatively, the solid substrate may include additional tobacco or non-tobacco volatile flavor compounds, so as to be released when the substrate is heated.

It should be noted that, a heating manner of the heating element 10 includes but is not limited to resistive heating, electromagnetic heating, or infrared heating. A shape of the heating element 10 includes but is not limited to a needle, a pin, or a sheet.

It should be further noted that, Different from the example in FIG. 1, in other examples, the heating element 10 is configured to surround at least a part of the aerosol generating article B for heating. That is, a usually called heating manner such as circumferential heating, peripheral heating, or the like is also feasible.

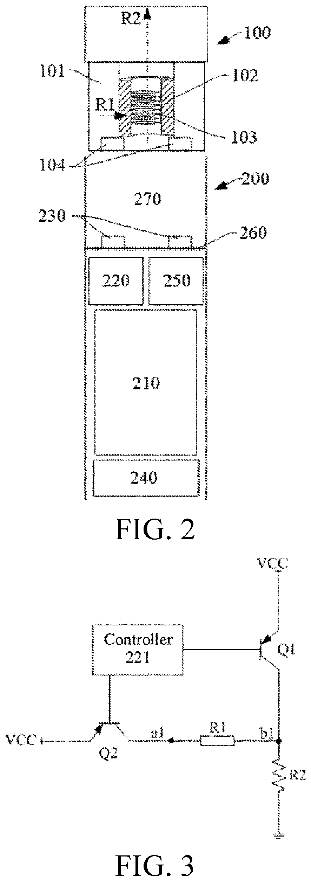

FIG. 2 is a schematic diagram of another aerosol generating device according to an implementation of this application.

As shown in FIG. 2, the aerosol generating device includes an atomizer 100 that stores a liquid aerosol-forming substrate and heats and atomizes the aerosol-forming substrate to generate an aerosol, and a power supply apparatus 200 that supplies power to the atomizer 100.

In an optional implementation, for example, as shown in FIG. 2, the power supply apparatus 200 includes a receiving cavity 270 that is arranged on an end along a length direction and configured to receive and accommodate at least a part of the atomizer 100. The power supply apparatus 200 further includes a first electrical contact 230 that is at least partially exposed on a surface of the receiving cavity 270, and the first electrical contact is configured to form an electrical connection with the atomizer 100 when at least a part of the atomizer 100 is received and accommodated in the power supply apparatus 200 to further supply power to the atomizer 100.

According to a preferred implementation shown in FIG. 2, an end portion of the atomizer 100 opposite to the power supply apparatus 200 along the length direction is provided with a second electrical contact 104, so that when at least a part of the atomizer 100 is received in the receiving cavity 270, the second electrical contact 104 forms conductivity through being in contact with and abutting against the first electrical contact 230.

A sealing member 260 is arranged inside the power supply apparatus 200, and at least a part of an internal space of the power supply apparatus 200 is separated through the sealing member 260 to form the receiving cavity 270. In the preferred implementation shown in FIG. 2, the sealing member 260 is configured to extend along a cross section direction of the power supply apparatus 200, and is preferably prepared by using a flexible material such as silica gel, so as to prevent the aerosol-forming substrate seeping from the atomizer 100 to the receiving cavity 270 from flowing to a circuit 220, an airflow sensor 250, and other components inside the power supply apparatus 200.

In the preferred implementation shown in FIG. 2, the power supply apparatus 200 further includes a battery cell 210 that faces away from the receiving cavity 270 along the length direction and configured to supply power.

The power supply apparatus 200 further includes a circuit 220, where the circuit 220 operably guides a current between the battery cell 210 and the first electrical contact 230.

The power supply apparatus 200 further includes an airflow sensor 250 configured to sense an inhalation airflow generated when a user inhales the atomizer 100, and the circuit 220 further controls the battery cell 210 to output power to the atomizer 100 according to a sensing signal of the airflow sensor 250.

Further, in the preferred implementation shown in FIG. 2, a charging interface 240 is provided on another end of the power supply apparatus 200 that faces away from the receiving cavity 270, and the charging interface is configured to charge the battery cell 210.

In an optional embodiment, for example, in the embodiment shown in FIG. 2, the atomizer 100 includes:

a liquid storage cavity 101, configured to store the liquid aerosol-forming substrate;
a heating element 103, configured to heat and atomize the liquid aerosol-forming substrate to generate an aerosol; and
a liquid guiding element 102, configured to transfer the liquid aerosol-forming substrate between the liquid storage cavity 101 and the heating element 103.

In an optional implementation, the liquid aerosol-forming substrate preferably includes a material containing tobacco, and the material containing tobacco includes volatile tobacco flavor compounds released from the liquid aerosol-forming substrate when being heated. Alternatively or in addition, the liquid aerosol-forming substrate may include a non-tobacco material. The liquid aerosol-forming substrate may include water, ethanol or another solvent, plant extracts, nicotine solution, and natural or artificial flavoring agents. Preferably, the liquid aerosol-forming substrate further includes an aerosol forming agent. An example of a suitable aerosol forming agent is glycerin and/or propylene glycol.

In the embodiment shown in FIG. 2, the liquid guiding element 102 is constructed in a shape of a hollow column that extending along a longitudinal direction of the atomizer 100, and the heating element 103 is formed inside the columnar hollow of the liquid guiding element 102. During use, as shown by an arrow R1, the liquid aerosol-forming substrate of the liquid storage cavity 101 is absorbed by an outer surface of the liquid guiding element 102 along a radial direction, and is then transferred to the heating element 103 on an inter surface to be heated and atomized to generate an aerosol; and as shown by an arrow R2 in FIG. 1, the generated aerosol is outputted from the columnar hollow of the liquid guiding element 102 along the longitudinal direction of the atomizer 100.

In another variant implementation, the liquid guiding element 102 includes flexible fiber, such as cotton fiber, non-woven fabric, glass fiber ropes, and the like; or includes porous ceramics with a microporous structure. In a specific implementation, a structure of the liquid guiding element 102 using porous ceramics may be in any one of a plurality of regular or irregular shapes, such as a shape described in Patent CN212590248U.

In some embodiments, the heating element 103 is constructed as a heating wire or a heating sheet, and is combined on the liquid guiding element 102 through contact. Alternatively, in another variant implementation, the heating element 103 may be combined on the liquid guiding element 102 through printing, deposition, sintering, physical assembly, or the like. In some other variant implementations, the liquid guiding element 102 using porous ceramics may include a flat surface or a curved surface configured to support the heating element 103, and the heating element 103 is formed on the flat surface or the curved surface of the liquid guiding element 102 through mounting, printing, deposition, or the like.

A material of the heating element 103 may be a metal material having proper impedance, metal alloy, graphite, carbon, conductive ceramics, or another composite material of a ceramic materials and a metal material. A proper metal or alloy material includes at least one of nickel, cobalt, zirconium, titanium, nickel alloy, cobalt alloy, zirconium alloy, titanium alloy, nickel-chromium alloy, nickel-iron alloy, iron-chromium alloy, iron-chromium-aluminum alloy, titanium alloy, iron-manganese-aluminum-base alloy, or stainless steel.

Based on the aerosol generating devices shown in FIG. 1 and FIG. 2, a temperature of the heating element (10, 103) for heating the aerosol-forming substrate needs to be monitored, to facilitate controlling the battery cell (20, 220) to supply power to the heating element (10, 103), further causing the user to have better experience.

In an optional implementation, a real-time temperature of the heating element (10, 103) is sensed through a thermosensitive element arranged adjacent to the heating element (10, 103). A resistance value of the thermosensitive element may vary depending on the heating temperature. Generally, the thermosensitive element is classified into a positive temperature coefficient thermosensitive element and a negative temperature coefficient thermosensitive element according to different temperature coefficients.

In another optional implementation, the heating element (10, 103) may be both configured to heat the aerosol-forming substrate, and used as the thermosensitive element configured to sense the real-time temperature. For example, a resistance material of the heating element 103 may be selected from a metal or alloy material with a proper resistance temperature coefficient, such as a positive temperature coefficient or a negative temperature coefficient. In this way, the heating element 103 may be both configured to generate heat and used as a sensor configured to sense the real-time temperature of the heating element 103.

For ease of description, the following examples are described for a case that the heating element may be both configured to heat the aerosol-forming substrate and used as the thermosensitive element configured to sense the real-time temperature with reference to FIG. 2:

FIG. 3 is a schematic diagram of basic components of an embodiment of the circuit 220.

As shown in FIG. 3, the circuit 220 includes:

a first switch tube Q1, located between the battery cell 210 and the heating element 103 (shown by R2 in FIG. 3), where when the first switch tube Q1 is turned on, the first switch tube is configured to cause the battery cell 210 to supply power to the heating element 103; and

a sampling resistor R1, located between a second switch tube Q2 and the heating element 103. Specifically, a first end of the sampling resistor R1 is connected to the second switch tube Q2, and a second end thereof is connected to the heating element 103. The sampling resistor R1 is a standard resistor with a basically constant resistance value, where the resistance value ranges from 0.1 m$\Omega$ to 1000 K$\Omega$, and the sampling resistor is configured to form a series connection with the heating element 103 when the second switch tube Q2 is turned on, to further form a detection loop that may detect voltages of the sampling resistor R1 and the heating element 103 through voltage dividing. Certainly, when detection does not need to be performed, the second switch tube Q2 is turned off to close the detection loop.

In the specific implementation shown in FIG. 3, the first end of the heating element 103 includes two paths, where the first path is connected to the first switch tube Q1, and the second path is configured to form a series connection with the sampling resistor R1. The second end of the heating element 103 is grounded, so that a potential of the second end of the heating element 103 is 0.

Further, in the specific implementation shown in FIG. 3, turn-on and turn-off of the first switch tube Q1 and the second switch tube Q2 are controlled by a controller 221, and the first switch tube Q1 and the second switch tube Q2 are not turned on simultaneously. The controller 221 includes but is not limited to a single-chip microcomputer MCU. When power needs to be supplied to the heating element 103, the controller 221 controls the first switch tube Q1 to be turned on and the second switch tube Q2 to be turned off, to cause the battery cell 210 to supply power to the heating element 103. When the heating temperature of the heating element 103 needs to be detected, the controller 221 controls the first switch tube Q1 to be turned off and the second switch tube Q2 to be turned on, so that the heating temperature may be determined through related electrical characteristics such as voltages of the detection loop, the sampling resistor R1, and the heating element 103.

A voltage between two ends of the sampling resistor R1 is denoted by V1, and a voltage between two ends of the heating element 103 is denoted by V2. In a detection process, the controller 221 may denote a voltage at the first end of the sampling resistor R1, namely, a sampling point a1 in FIG. 3 by Va1, where the voltage is a voltage between two ends of the detection loop; and sample a voltage Vb1 at the first end of the heating element 103, namely, a sampling point b1 in FIG. 3. Because the second end of the heating element 103 in FIG. 3 is grounded, the voltage Vb 1 at the sampling point b 1 is equal to V2, and the voltage V1 between the two ends of the sampling resistor R1 is equal to Va1 minus V2.

Based on the foregoing related electrical characteristics, the controller 221 may determine a key K, to find a heating temperature corresponding to the key K by querying pre-stored correspondence data between keys and heating temperatures according to the key.

Specifically, this step may be implemented through the following different manners:

$$(1). \quad \frac{V_{a1}-V_{b1}}{V_{b1}} = \frac{R_1}{R_2},$$

where a K value is $\frac{V_{a1}-V_{b1}}{V_{b1}}$ , namely, a ratio of the voltage between the two ends of the sampling resistor R1 to the voltage between the two ends of the heating element 103. The sampling resistor R1 is a given standard resistor, and a resistance value thereof is constant; and R2 is body resistance of the heating element 103. When the correspondence data between keys and heating temperatures is established, $\frac{R_1}{R_2}$ needs to be converted into a correspondence heating temperature according to a TCR calculation formula (or according to a reference table if an independent thermosensitive element is arranged) in combination with the resistance value of the sampling resistor R1, so that a (K-T) temperature table may be formed and stored in the controller 221 or a memory. After the key K is determined, the corresponding heating temperature may be obtained through the (K-T) temperature table. It may be seen from this manner that, the corresponding heating temperature may be obtained with calculating the body resistance R2 of the heating element 103. In addition, if a VCC voltage fluctuates and changes, voltage values of $V_{a1}$, $\frac{V_{a1}}{V_{b1}}$ , and $V_{b1}$ proportionally change at the same time, so that a good anti-interference effect can be achieved without an additional filter circuit. It should be noted that, a reverse K value is also feasible, namely, the ratio of the voltage between the two ends of the sampling resistor R1 to the voltage between the two ends of the heating element 103 includes a K value $\frac{V_{b1}}{V_{a1}-V_{b1}}$ .

$$(2). \quad \frac{V_{a1}}{V_{b1}} = \frac{R_1+R_2}{R_2},$$

where a K value is $\frac{V_{a1}}{V_{b1}}$ , namely, a ratio of the voltage between the two ends of the detection loop to the voltage between the two ends of the heating element 103. For other details, reference may be made to the manner 1.

$$(3). \quad \frac{V_{a1}}{V_{a1}-V_{b1}} = \frac{R_1+R_2}{R_1},$$

where a K value is $\frac{V_{a1}}{V_{a1}-V_{b1}}$ , namely, a ratio of the voltage between the two ends of the detection loop to the voltage between the two ends of the sampling resistor R1. For other details, reference may be made to the manner 1.

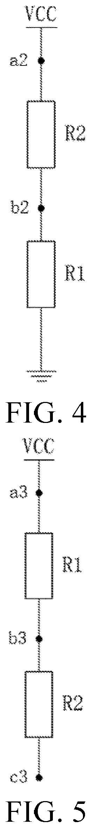

Further, FIG. 4 shows a schematic diagram of basic components of another embodiment of the circuit 220. Different from the example in FIG. 3, positions of the sampling resistor R1 and the heating element 103 (shown by R2 in the figure) are exchanged.

Similar to FIG. 3, the key K may be determined in the following different manners, to further determine the heating temperature:

$$(11). \quad \frac{V_{a2}-V_{b2}}{V_{b2}} = \frac{R_2}{R_1},$$

where a K value is $\frac{V_{a2}-V_{b2}}{V_{b2}}$ , namely, a ratio of the voltage between the two ends of the heating element 103 to the voltage between the two ends of the sampling resistor R1.

$$(12). \quad \frac{V_{a2}}{V_{b2}} = \frac{R_1+R_2}{R_1},$$

where a K value is $\frac{V_{a2}-V_{b2}}{V_{b2}}$ , namely, a ratio of the voltage between the two ends of the detection loop to the voltage between the two ends of the sampling resistor R1.

$$(13). \quad \frac{V_{a2}}{V_{a2}-V_{b2}} = \frac{R_1+R_2}{R_2},$$

$$\frac{V_{a2}}{V_{a2}-V_{b2}}$$

where a K value is , namely, a ratio of the voltage between the two ends of the detection loop to the voltage between the two ends of the heating element 103.

Further, FIG. 5 shows a schematic diagram of basic components of still another embodiment of the circuit 220. Different from the example in FIG. 3, the second end of the heating element 103 is not grounded, and the controller 221 denotes a voltage sampled or detected at the second end c3 of the heating element 103 as $V_{c3}$.

Similar to FIG. 3, the key K may be determined in the following different manners, to further determine the heating temperature:

$$(21).\ \frac{V_{a3}-V_{b3}}{V_{b3}-V_{c3}} = \frac{R_1}{R_2},$$

where a K value is $\frac{V_{a3}-V_{b3}}{V_{b3}-V_{c3}}$ , namely, a ratio of the voltage between the two ends of the sampling resistor R1 to the voltage between the two ends of the heating element 103.

$$(22).\ \frac{V_{a3}-V_{c3}}{V_{b3}-V_{c3}} = \frac{R_1+R_2}{R_2},$$

where a K value is $\frac{V_{a3}-V_{c3}}{V_{b3}-V_{c3}}$ , namely, a ratio of the voltage between the two ends of the detection loop to the voltage between the two ends of the heating element 103.

$$(23).\ \frac{V_{a3}-V_{c3}}{V_{a3}-V_{b3}} = \frac{R_1+R_2}{R_1},$$

where a K value is $\frac{V_{a3}-V_{c3}}{V_{a3}-V_{b3}}$ , namely, a ratio of the voltage between the two ends of the detection loop to the voltage between the two ends of the sampling resistor R1.

It can be easily figured out that, similar to FIG. 4, by exchanging positions of the sampling resistor R1 and the heating element 103 in FIG. 5, the corresponding key K may also be determined, to further determine the heating temperature.

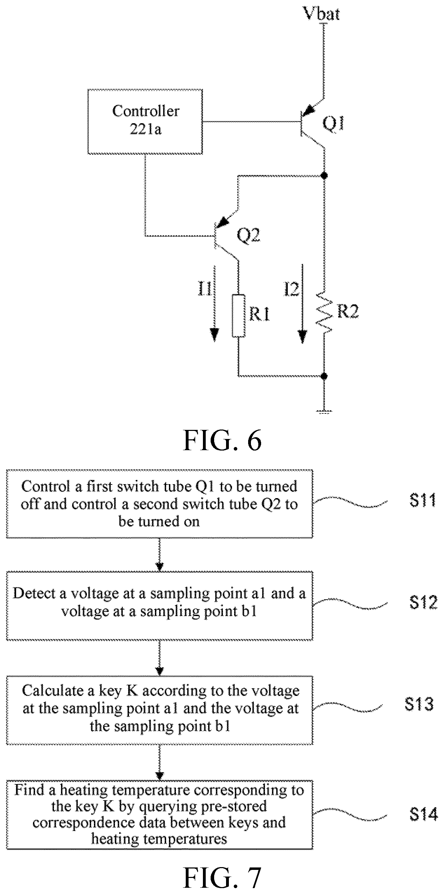

Further, FIG. 6 shows a schematic diagram of basic components of still another embodiment of the circuit 220. Different from the example in FIG. 3, the sampling resistor R1 and the heating element 103 are connected in parallel; when the controller 221a controls the first switch tube Q1 and the second switch tube Q2 to be turned on simultaneously, a detection loop is formed between the sampling resistor R1 and the heating element 103; and when detection does not need to be performed, the controller controls the second switch tube Q2 to be turned off.

Similar to FIG. 3, the key K may be determined in the following different manners, to further determine the heating temperature:

$$(31).\ \frac{I_1}{I_2} = \frac{R_2}{R_1},$$

where a K value is $\frac{I_1}{I_2}$ , namely, a ratio of a current flowing through the sampling resistor R1 to a current flowing through the heating element 103.

$$(32).\ \frac{I_2}{I_1} = \frac{R_1}{R_2},$$

where a K value is $\frac{I_2}{I_1}$ , namely, a ratio of the current flowing through the heating element 103 to the current flowing through the sampling resistor R1.

In another embodiment, the controller is configured to control a ratio of any two electrical characteristics of an electrical characteristic of the detection loop, an electrical characteristic of the sampling resistor, and an electrical characteristic of the thermosensitive element to be a preset value or fall within a preset range.

Specifically, based on the aerosol generating device shown in FIG. 1, a temperature of the heating element 10 needs to be controlled at different stages. For example, at a preheating stage, the temperature of the heating element 10 needs to reach a maximum temperature quickly and remains for a period of time under the maximum temperature; and at an inhalation stage or a constant temperature stage, the temperature of the heating element 10 needs to be controlled to be a preset value or fall within a preset temperature range. Therefore, by directly controlling the ratio of any two electrical characteristics to be the preset value or fall within the preset range through the controller, the temperature of the heating element 10 may be controlled. Using the preheating stage as an example, the controller may determine whether the ratio of any two electrical characteristics reaches the preset value, to further determine whether the temperature of the heating element 10 reaches the maximum temperature, so as to control the battery cell 20 to supply power to the heating element 30.

In this embodiment, for the ratio of any two electrical characteristics, reference may be made to the descriptions of FIG. 3 to FIG. 6 and the foregoing content, and details are not described herein again.

Another implementation of this application further provides a control method for an aerosol generating device, and for the aerosol generating device, reference may be made to the foregoing content.

The method includes:
determining a ratio according to any two electrical characteristics of an electrical characteristic of a detection loop, an electrical characteristic of a sampling resistor, and an electrical characteristic of a thermosensitive element, and determining a temperature for heating an aerosol-forming substrate.

The following describes a control process of the aerosol generating device in FIG. 2 with reference to FIG. 3 and FIG. 7:

Step S11. Control the first switch tube Q1 to be turned off and control the second switch tube Q2 to be turned on.

Step S12. Open a detection port, and detect a voltage at the sampling point a1 and a voltage at the sampling point b1, where the voltage at a1 is denoted by $V_{a1}$, and the voltage at b1 is denoted by $V_{b1}$.

Step S13. Calculate a key K according to the voltage at the sampling point a1 and the voltage at the sampling point b1, where a K value is $\dfrac{V_{a1} - V_{b1}}{V_{b1}}$, namely, a ratio of the voltage between the two ends of the sampling resistor R1 to the voltage between the two ends of the heating element 103.

Step S14. Find a heating temperature corresponding to the key K by querying pre-stored correspondence data between keys and heating temperatures, where a heating temperature corresponding to the key

$$K = \frac{V_{a1} - V_{b1}}{V_{b1}}$$

is queried in a pre-stored (K-T) temperature table.

It should be noted that, the specification and the accompanying drawings of this application illustrate preferred embodiments of this application, but this application is not limited to the embodiments described in this specification. Further, a person of ordinary skill in the art may make improvements or modifications according to the foregoing descriptions, and all the improvements and modifications shall fall within the protection scope of the appended claims of this application.

**Claims**

1. An aerosol generating device, configured to heat an aerosol-forming substrate to generate an aerosol, comprising:

    a battery cell, configured to supply power;
    a thermosensitive element, a resistance value thereof varying depending on a heating temperature;
    a sampling resistor, configured to be electrically connected to the thermosensitive element to form a detection loop; and
    a controller, configured to determine the heating temperature according to a ratio of any two electrical characteristics of an electrical characteristic of the detection loop, an electrical characteristic of the sampling resistor, and an electrical characteristic of the thermosensitive element.

2. The aerosol generating device according to claim 1, wherein the controller is further configured to detect the any two electrical characteristics.

3. The aerosol generating device according to claim 1, wherein the controller is further configured to obtain the heating temperature according to the ratio and pre-stored correspondence data between ratios and heating temperatures.

4. The aerosol generating device according to claim 3, wherein the controller is further configured to query the correspondence data.

5. The aerosol generating device according to claim 1, wherein the sampling resistor is connected to the thermosensitive element in series.

6. The aerosol generating device according to claim 5, wherein the electrical characteristic comprises a voltage; and
the ratio comprises at least one of the following:
a ratio of a voltage between two ends of the detection loop to a voltage between two ends of the sampling resistor, a ratio of the voltage between the two ends of the detection loop to a voltage between two ends of the thermosensitive element, or a ratio of the voltage between the two ends of the sampling resistor to the voltage between the two ends of the thermosensitive element.

7. The aerosol generating device according to claim 1, wherein the sampling resistor is connected to the thermosensitive element in parallel.

8. The aerosol generating device according to claim 7, wherein the electrical characteristic comprises a current; and
the ratio comprises a ratio of a current flowing through the sampling resistor to a current flowing through the thermosensitive element.

**9.** The aerosol generating device according to claim 1, further comprising a switch tube, wherein
the controller is further configured to control the switch tube to turn on or turn off an electrical connection between the detection loop and the battery cell.

**10.** The aerosol generating device according to claim 1, further comprising a heating element, configured to heat the aerosol-forming substrate, wherein
the thermosensitive element is arranged adjacent to the heating element.

**11.** The aerosol generating device according to claim 1, wherein the thermosensitive element is configured to heat the aerosol-forming substrate.

**12.** The aerosol generating device according to claim 1, wherein the aerosol-forming substrate is in a solid form or a liquid form.

**13.** An aerosol generating device, configured to heat an aerosol-forming substrate to generate an aerosol, comprising:

a battery cell, configured to supply power;
a thermosensitive element, a resistance value thereof varying depending on a heating temperature;
a sampling resistor, configured to be electrically connected to the thermosensitive element to form a detection loop; and
a controller, configured to control a ratio of any two electrical characteristics of an electrical characteristic of the detection loop, an electrical characteristic of the sampling resistor, and an electrical characteristic of the thermosensitive element to be a preset value or fall within a preset range.

**14.** An aerosol generating device, comprising:

a battery cell, configured to supply power;
a heating element, configured to heat an aerosol-forming substrate to generate an aerosol;
a sampling resistor, configured to be electrically connected to the heating element to form a detection loop; and
a controller, configured to determine a heating temperature of the heating element according to a ratio of any two electrical characteristics of an electrical characteristic of the detection loop, an electrical characteristic of the sampling resistor, and an electrical characteristic of the heating element.

**15.** A control method for an aerosol generating device, the method comprising:

determining a ratio according to any two electrical characteristics of an electrical characteristic of a detection loop, an electrical characteristic of a sampling resistor, and an electrical characteristic of a thermosensitive element, and determining a temperature for heating an aerosol-forming substrate.

FIG. 1

FIG. 2

FIG. 3

FIG. 4

FIG. 5

FIG. 6

| |
|---|
| Control a first switch tube Q1 to be turned off and control a second switch tube Q2 to be turned on — S11 |
| Detect a voltage at a sampling point a1 and a voltage at a sampling point b1 — S12 |
| Calculate a key K according to the voltage at the sampling point a1 and the voltage at the sampling point b1 — S13 |
| Find a heating temperature corresponding to the key K by querying pre-stored correspondence data between keys and heating temperatures — S14 |

FIG. 7

## INTERNATIONAL SEARCH REPORT

| International application No. |
| --- |
| **PCT/CN2022/127396** |

### A. CLASSIFICATION OF SUBJECT MATTER

A24F 40/465(2020.01)i; A24F 40/40(2020.01)i

According to International Patent Classification (IPC) or to both national classification and IPC

### B. FIELDS SEARCHED

Minimum documentation searched (classification system followed by classification symbols)

A24F

Documentation searched other than minimum documentation to the extent that such documents are included in the fields searched

Electronic data base consulted during the international search (name of data base and, where practicable, search terms used)

CNTXT; CNKI; WPABSC; ENTXTC; WPABS; ENTXT: 气溶胶, 电子烟, 雾化器, 电阻, 阻值, 加热, 比值, 比例, 调整, 调节, 控制, 热敏, resistance, control, cigarette, atomizer, resistive, aerosol, current

### C. DOCUMENTS CONSIDERED TO BE RELEVANT

| Category* | Citation of document, with indication, where appropriate, of the relevant passages | Relevant to claim No. |
| --- | --- | --- |
| X | CN 105027016 A (PHILIP MORRIS PRODUCTS S.A.) 04 November 2015 (2015-11-04) description, paragraphs [0078]-[0098], and figures 1-3 | 1-15 |
| A | US 2020237013 A1 (JAPAN TOBACCO INC.) 30 July 2020 (2020-07-30) entire document | 1-15 |
| A | CN 214229854 U (SHENZHEN FIRST UNION TECHNOLOGY CO., LTD.) 21 September 2021 (2021-09-21) entire document | 1-15 |

☐ Further documents are listed in the continuation of Box C.　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **03 January 2023** | **12 January 2023** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/127396**

| Patent document cited in search report | | | Publication date (day/month/year) | Patent family member(s) | | | Publication date (day/month/year) |
|---|---|---|---|---|---|---|---|
| CN | 105027016 | A | 04 November 2015 | BR | 112015004669 | A2 | 04 July 2017 |
| | | | | EP | 3002657 | A2 | 06 April 2016 |
| | | | | US | 2016331038 | A1 | 17 November 2016 |
| | | | | CA | 2880481 | A1 | 20 March 2014 |
| | | | | EP | 2895930 | A2 | 22 July 2015 |
| | | | | ES | 2608868 | T3 | 17 April 2017 |
| | | | | KR | 20150084779 | A | 22 July 2015 |
| | | | | CN | 105446393 | A | 30 March 2016 |
| | | | | NZ | 705806 | A | 25 August 2017 |
| | | | | AU | 2013314436 | A1 | 23 April 2015 |
| | | | | AR | 092531 | A1 | 22 April 2015 |
| | | | | MY | 169408 | A | 01 April 2019 |
| | | | | JP | 2016028398 | A | 25 February 2016 |
| | | | | WO | 2014040988 | A2 | 20 March 2014 |
| | | | | TW | 201421180 | A | 01 June 2014 |
| | | | | RU | 2015113364 | A | 10 November 2016 |
| | | | | US | 2015237916 | A1 | 27 August 2015 |
| | | | | KR | 20160009108 | A | 25 January 2016 |
| | | | | RU | 2621468 | C1 | 06 June 2017 |
| | | | | ES | 2621163 | T3 | 03 July 2017 |
| | | | | PH | 12015500131 | A1 | 02 March 2015 |
| | | | | WO | 2014040988 | A3 | 23 April 2015 |
| | | | | SG | 11201501700 | A1 | 29 April 2015 |
| | | | | IN | 201500754 | P1 | 10 July 2015 |
| | | | | VN | 42970 | A | 27 July 2015 |
| | | | | JP | 2015531600 | W | 05 November 2015 |
| | | | | ZA | 201500400 | A | 27 January 2016 |
| | | | | HK | 1208920 | A0 | 18 March 2016 |
| | | | | KR | 101619034 | B1 | 18 May 2016 |
| | | | | EP | 3002657 | A3 | 15 June 2016 |
| | | | | JP | 5971829 | B2 | 17 August 2016 |
| | | | | KR | 101660214 | B1 | 26 September 2016 |
| | | | | HK | 1216193 | A0 | 21 October 2016 |
| | | | | EP | 2895930 | B1 | 02 November 2016 |
| | | | | JP | 6046231 | B2 | 14 December 2016 |
| | | | | ID | 201701635 | A | 03 March 2017 |
| | | | | CN | 105027016 | B | 08 March 2017 |
| | | | | EP | 3002657 | B1 | 22 March 2017 |
| | | | | RU | 2619372 | C2 | 15 May 2017 |
| | | | | AU | 2013314436 | B2 | 01 June 2017 |
| | | | | US | 9713345 | B2 | 25 July 2017 |
| | | | | SG | 11201501700 | B | 07 August 2017 |
| | | | | HK | 1208920 | A1 | 11 August 2017 |
| | | | | TW | 595340 | B1 | 11 August 2017 |
| | | | | HK | 1216193 | A1 | 12 January 2018 |
| | | | | US | 9872521 | B2 | 23 January 2018 |
| | | | | PH | 12015500131 | B1 | 13 February 2018 |
| | | | | CN | 105446393 | B | 23 February 2018 |
| | | | | MX | 354893 | B | 23 March 2018 |
| | | | | IL | 237099 | A | 28 February 2019 |

Form PCT/ISA/210 (patent family annex) (January 2015)

**INTERNATIONAL SEARCH REPORT**
Information on patent family members

International application No.

**PCT/CN2022/127396**

| Patent document cited in search report | | | Publication date (day/month/year) | Patent family member(s) | | | Publication date (day/month/year) |
|---|---|---|---|---|---|---|---|
| | | | | BR | 112015004669 | B1 | 29 March 2022 |
| | | | | MX | 2015003149 | A1 | 05 August 2015 |
| US | 2020237013 | A1 | 30 July 2020 | JP | 2021129571 | A | 09 September 2021 |
| | | | | JP | WO2019082282 | A1 | 26 November 2020 |
| | | | | WO | 2019082282 | A1 | 02 May 2019 |
| | | | | KR | 20200044911 | A | 29 April 2020 |
| | | | | CA | 3077663 | A1 | 02 May 2019 |
| | | | | EP | 3701819 | A1 | 02 September 2020 |
| | | | | CN | 111246760 | A | 05 June 2020 |
| | | | | JP | 6923666 | B2 | 25 August 2021 |
| | | | | JP | 6936414 | B2 | 15 September 2021 |
| | | | | EP | 3701819 | A4 | 10 November 2021 |
| | | | | JP | 2022008303 | A | 13 January 2022 |
| CN | 214229854 | U | 21 September 2021 | | None | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202111252866

- CN 212590248 U